# EUROPEAN PATENT SPECIFICATION

(11) **EP 2 730 834 B1**
(45) Date of publication and mention of the grant of the patent: **09.03.2016**
(21) Application number: 13192235.3
(22) Date of filing: 08.11.2013
(51) Int. Cl.: F21S 2/00, F21S 4/00, H05K 1/14, F21V 21/005, F21V 23/06, H01R 13/514, H01R 25/16, F21Y 115/10, F21Y 103/00, H05K 1/05, H05K 3/36, H05K 3/40

(54) **LED Illumination Device**
LED-Beleuchtungsvorrichtung
Dispositif d'éclairage à DEL

(30) Priority: 13.11.2012 CN 201210454665
(43) Date of publication of application: 14.05.2014
(73) Proprietor: OSRAM GmbH, 80807 München (DE)
(72) Inventor: Zhong, Chuanpeng, 518053 Shenzhen Guangdong (CN); Liu, Tingming, 518053 Shenzhen Guangdong (CN); Ming, Yusheng, 518053 Shenzhen Guangdong (CN); Yang, Jianghui, 518053 Shenzhen Guangdong (CN)

(56) References cited:
- EP-A2- 1 848 254
- WO-A2-2012/036465
- DE-U1-202006 011 477
- KR-B1- 100 970 508
- US-A- 3 573 707
- US-A- 5 285 352
- US-A1- 2006 289 201
- US-A1- 2009 044 969
- US-A1- 2012 025 219

## Description

### Technical Field

The present invention relates to an LED illumination device.

### Background Art

As is known to all, LED illumination has irreplaceable advantages. It is energy saving, has very low power consumption, has a nearly 100% electro-optical power conversion, can save more than 80% of energy with the same illumination efficiency compared with the traditional light sources, and has a long lifespan. In view of the above advantages, people more and more frequently use LEDs as light sources. Several LED chips are usually arranged on one circuit board, and in order to obtain different types of illumination effects, it may be necessary to connect multiple circuit boards. In the prior art, there are several connecting methods. For example, the adjacent circuit boards are connected by a conductor, and the conductor needs to be welded to the corresponding electrical connection position of the circuit board. The advantage of this method lies in low cost. However, this method also has obvious defects, for example, the welding of the conductor must be done manually, which is not conducive to automated production. In addition, this connecting method has low safety.

The prior art discloses another connecting method. The connecting method is also applicable to a conductor, but the conductor is fixed to the circuit board by a connecting cap. The advantage of this connecting method is that the electrical connection region between the conductor and the connecting cap is covered, which improves the safety. However, this connecting method also has the disadvantage of being very complicated, which is not conducive to automated production. Moreover, the connecting cap is in contact with the electrodes on the circuit board, which will lead to aging of the connecting cap. In addition, the cost of the connecting cap is high.

EP 1 848 254 A2 describes a PCB module according to the preamble of claim 1, comprising a printed circuit board that has conductor traces disposed in the PCB. On the PCB at least one connecting means is formed by which means this PCB can be directly connected mechanically and electrically to a similar PCB having an identical or similar connecting means. The PCB module may have a light emitting diode on a flat side or at an edge which is supplied with power by the presence of conductor traces in the printed circuit board.

US 2006/0289201 A1 describes a backlight assembly and a display device having the backlight assembly where the backlight assembly includes a plurality of light sources for emitting light and a plurality of metal core printed circuit boards on which the light sources are mounted. The metal core printed circuit boards are directly connected to each other in predetermined regions to emit light in a surface direction. A method of assembling the backlight assembly is further described.

### Summary of the Invention

In order to solve the above technical problem, the present invention proposes an LED illumination device, which has more reliable connection between circuit boards, and has higher safety and lower cost.

The object of the present invention is achieved by an LED illumination device, comprising at least two light-emitting modules in serial connection, wherein the light-emitting module comprises a circuit board and at least one LED chip arranged on the circuit board, wherein the circuit board comprises a first superimposed portion and a second superimposed portion at two opposite ends of the circuit board, wherein a first electrical connection surface is formed in the first superimposed portion, and a second electrical connection surface is formed in the second superimposed portion, wherein the first superimposed portion of the circuit board of one of the light-emitting modules at least partially overlaps the second superimposed portion of the circuit board of an adjacent light-emitting module, and the first electrical connection surface of the circuit board of one of the light-emitting modules is in electrical connection with the second electrical connection surface of the circuit board of an adjacent light-emitting module. In the design solution of the present invention, the adjacent circuit boards are not connected by a conductor, which simplifies the production process, and avoids manual method. Thus, the LED illumination device according to the present invention allows automated production, which greatly improves the speed of production of the products and also improves the product yield.

Also, the first superimposed portion is formed as a first step-like structure, the second superimposed portion is formed as a second step-like structure, the first step-like structure of the circuit board of one of the light-emitting modules is complementary to the second step-like structure of the circuit board of an adjacent light-emitting module, such that connection portions of the circuit boards of the adjacent light-emitting modules are flush with each other in an overlapping region. In the LED illumination device according to the present invention, for example, the first step-like structure of one circuit board can be joined with the second step-like structure of the adjacent circuit board. Since the shapes of the two step-like structures are complementary, after the joining, the two circuit boards are integrally connected, which enables the LED illumination device according to the present invention to be more beautiful. Moreover, no gap will appear in the connection region between the two circuit boards, which makes the connection between the two circuit boards closer, prevents the conductive region from being exposed to the outside, and thereby further improves the safety of the LED illumination device according to the present invention.

Further, the first step-like structure and the second step-like structure respectively comprise a first abutment surface in parallel with the mounting surface of the circuit board and a second abutment surface perpendicular to the mounting surface, wherein the first abutment surface and the second abutment surface form connection surfaces between the circuit boards. The step-like structures significantly increase the contact area between the circuit boards, thereby ensuring reliable mechanical connection performance between the circuit boards.

Additionally, the first abutment surface is designed in a square shape. The circuit boards not only can be directly connected in a straight line, but also can be directly connected to be perpendicular to each other. When the circuit boards are arranged to be perpendicular to each other, the first abutment surface in square shape can ensure complete coincidence between the first abutment surfaces of adjacent circuit boards, so that no region is exposed to the outside, thereby advantageously avoiding that the conductive region is exposed to the outside.

Furthermore, the circuit board comprises a basic material layer, an insulating layer arranged on the basic material layer, a first conductive layer arranged on the insulating layer, and a second conductive layer arranged on the first conductive layer. In addition, the circuit board comprises an electrical connection structure, wherein the electrical connection structure includes a conductive column, one end of the conductive column being in electrical connection with the second conductive layer and/or the first conductive layer, and a free end surface of the other end of the conductive column constituting at least a portion of the first abutment surface and forming the first electrical connection surface or the second electrical connection surface. In the design solution of the present invention, one free end surface of the conductive column forms an electrical connection surface which forms apportion of the first abutment surface, that is, the electrical connection surface is flush with the first abutment surface. Thus, a portion having no electrical connection surface projects from the first abutment surface, and thereby, when the first abutment surfaces abut against each other, the electrical connection surfaces can be electrically connected with each other, without producing any negative impact on the contact abutment between the first abutment surfaces.

Further, the electrical connection structure further includes an insulating wall surrounding a circumferential surface of the conductive column, such that the conductive column is electrically isolated from the basic material layer. In the design solution of the present invention, the insulating wall enables the conductive column to be electrically isolated from an additional conductor portion of the circuit board which is not used for electrical connection.

Preferably, the first superimposed portion or the second superimposed portion of the circuit board of one of the light-emitting modules completely covers the second electrical connection surface or the first electrical connection surface of the circuit board of an adjacent light-emitting module, and the first superimposed portion and the second superimposed portion are formed on two opposite mounting surfaces of the circuit board, respectively. Since the electrical connection surface is completely covered by the superimposed portion, no conductive portion is exposed to the outside, which greatly improves the safety performance of the LED illumination device according to the present invention.

Further preferably, the first superimposed portion and the second superimposed portion are formed on two opposite mounting surfaces of the circuit board, respectively. In this way, two adjacent circuit boards can be joined together by partially overlapping each other at respective end regions.

Advantageously, the basic material layer is made of an aluminum material. The basic material layer made of aluminum can provide a rigid bearing structure for the circuit board, so as to provide a basic bearing profile for other material layers formed on the basic material layer. Further, the basic material layer made of aluminum has good thermal conductive performance, which is very conducive to the heat discharge.

Further advantageously, the first conductive layer is made of a copper material, and the second conductive layer is made of a nickel-gold material. The second conductive layer made of nickel-gold material can enhance the conductivity of the first conductive layer, and the Ni Au material can enhance the antiwear property of the first conductive layer.

Preferably, a conductive paste is applied between the first electrical connection surface and the second electrical connection surface. The conductive paste can significantly increases effective electrical connection area between the electrical connection surfaces, which thereby reduces the contact resistance, reduces the temperature of the region of the electrical connection surface, and further prolongs the lifespan of the circuit board.

According to the present invention, the first abutment surface and the second abutment surface of the circuit board of one of the light-emitting modules are in welded connection with the first abutment surface and the second abutment surface of the circuit board of an adjacent light-emitting module. The welded connection ensures reliable fixed connection between the circuit boards, thereby ensuring reliable electrical connection between the electrical connection surfaces.

It is to be understood that the features of the various exemplary embodiments described herein may be combined with each other, unless specifically noted otherwise.

### Brief Description of the Drawings

The drawings constitute a portion of the Description for further understanding of the present invention. These drawings illustrate the embodiments of the present invention and explain the principle of the present invention together with the Description. In the drawings, the same part is represented by the same reference sign. In the drawings,
Fig. 1 is a schematic diagram of one light-emitting module of the LED illumination device according to the present invention;
Fig. 2 is a sectional view of the circuit board of the light-emitting module of the LED illumination device according to the present invention;
Fig. 3 is a schematic diagram of the circuit boards of two unconnected light-emitting modules of the LED illumination device according to the present invention;
Fig. 4 is a schematic diagram of the opposite end regions of the two circuit boards shown in Fig. 2, viewed at a first angle; and
Fig. 5 is a schematic diagram of the opposite end regions of the two circuit boards shown in Fig. 2, viewed at a second angle.

### Detailed Description of the Embodiments

In the following detailed Description, reference is made to the accompanying drawings, which form a part hereof, and in which is shown by way of illustration specific embodiments in which the invention may be practiced. In this regard, directional terminology, such as "left" "right" "upper", "lower" etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

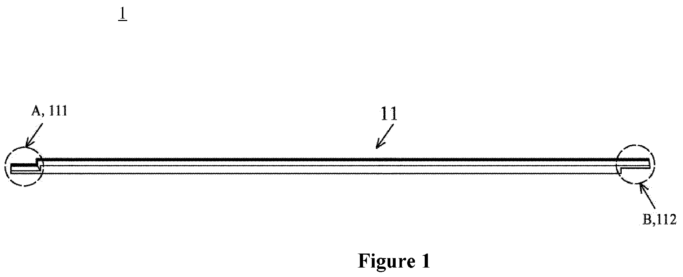

Fig. 1 is a schematic diagram of the circuit board 11 of one light-emitting module 1 of the LED illumination device 100 according to the present invention. In the design solution of the present invention, the LED illumination device 100 comprises a plurality of light-emitting modules 1, and these light-emitting modules are connected in series with each other. In Fig. 1, in order to describe the specific structure of the light-emitting module 1, only one light-emitting module 1 is shown, and the other light-emitting modules 1 which are not shown have the same structure as the light-emitting module 1 shown in Fig. 1.

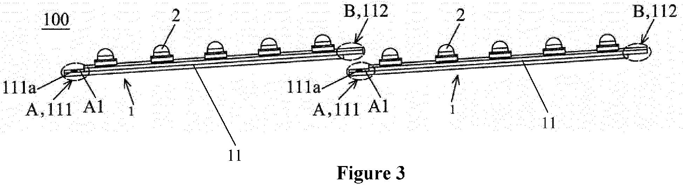

In the design solution of the present invention, the light-emitting module 1 comprises a circuit board 11 and at least one LED chip 2 (not shown in Fig. 1, referring to Figs. 3-5) arranged on the circuit board 11. As can be seen in Fig. 1, the circuit board 11 comprises a first superimposed portion 111 (the left side of the figure) and a second superimposed portion 112 (the right side of the figure) at two opposite ends of the circuit board 11. In an assembled state, the first superimposed portion 111 of the circuit board 11 of one of the light-emitting modules 1 at least partially overlaps the second superimposed portion 112 of the circuit board 11 of an adjacent light-emitting module 1. In the embodiment shown in the figure, the first superimposed portion 111 (one side of the upper surface of the circuit board 11 in the figure) and the second superimposed portion 112 (one side of the lower surface of the circuit board 11 in the figure) are formed on two opposite mounting surfaces of the circuit board 11, respectively.

In addition, in this embodiment, the first superimposed portion 111 is formed as a first step-like structure A, the second superimposed portion 112 is formed as a second step-like structure B, the first step-like structure A of the circuit board 11 of one of the light-emitting modules 1 is complementary to the second step-like structure B of the circuit board 11 of an adjacent light-emitting module 1, such that connection portions of the circuit boards 11 of the adjacent light-emitting modules 1 are flush with each other in an overlapping region.

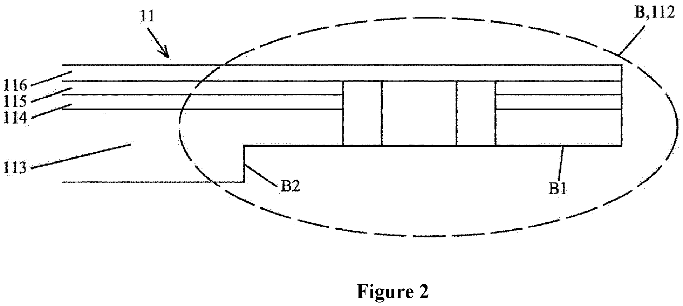

Fig. 2 is a sectional view of the circuit board 11 of the light-emitting module 1 of the LED illumination device 100 according to the present invention. The figure 2 shows a schematic diagram of the end region on the right side of the circuit board 11 shown in Fig. 1. Since the end region on the left side has the same structure, detailed description is only made on the end region on the right side. As can be seen from the figure, the end region on the right side is actually the second superimposed portion 112 which is designed as the second step-like structure B. The second step-like structure B comprise a first abutment surface B1 in parallel with the mounting surface of the circuit board and a second abutment surface B2 perpendicular to the mounting surface, wherein the first abutment surface B1 and the second abutment surface B2 form connection surfaces between the circuit boards 11. In a preferred design solution of the present invention, the first abutment surface B1 is designed in a square shape.

In addition, as can be seen from Fig. 2, the circuit board 11 comprises a basic material layer 113, an insulating layer 114 arranged on the basic material layer 113, a first conductive layer 115 arranged on the insulating layer 114, and a second conductive layer 116 arranged on the first conductive layer 115. In this embodiment, the basic material layer 113 is made of an aluminum material, the first conductive layer 115 is made of a copper material, and the second conductive layer 116 is made of Ni Au material.

Further, as can be further seen from Fig. 2, the circuit board 11 comprises an electrical connection structure 3, wherein the electrical connection structure 3 includes a conductive column 31, one end of the conductive column 31 being in electrical connection with the second conductive layer 116. In other embodiments of the present invention, one end of the conductive column 31 can also be in electrical connection with the first conductive layer 115, or in electrical connection with both the first and second conductive layers 115, 116. In addition, a free end surface of the other end of the conductive column 31 constitutes at least a portion of the first abutment surface B1 (constituting at least a portion of the first abutment surface A1 at the other end of the circuit board 11) and forms the second electrical connection surface 112a (forming the first electrical connection surface 111a at the other end of the circuit board 11). Further, as can be further seen from the figure, the electrical connection structure 3 further includes an insulating wall 32 surrounding a circumferential surface of the conductive column 31, such that the conductive column 31 is electrically isolated from the basic material layer 113. In this embodiment, the insulating wall 32 extends to the contact surface between the second conductive layer 116 and the first conductive layer 115, such that the conductive column 31 and the first conductive layer 115 are isolated from each other in the circumferential direction.

Fig. 3 is a schematic diagram of the circuit boards 11 of two unconnected light-emitting modules 1 of the LED illumination device 100 according to the present invention. As can be seen from the figure, each of the circuit boards 11 is arranged with a plurality of LED chips 2. In addition, the two light-emitting modules 1 need to be connected to each other at their end regions. The first abutment surface A1 of the first step-like structure A on the left side of each circuit board 11 which serves as the first superimposed portion 111, and the first electrical connection surface 111a which constitutes a portion of the first abutment surface A1 can be seen from the figure. Due to the angle of view, the second abutment surface B1 in the second step-like structure B serving as the second superimposed portion 112, and the second electrical connection surface 112a cannot be observed. After the two light-emitting modules 1 are connected together, the second superimposed portion 112 of the circuit board 11 of the light-emitting module 1 on the left side in the figure overlaps the first superimposed portion 111 of the circuit board 11 of the light-emitting module 1 on the right side, and the second electrical connection surface 112a of the circuit board 11 of the light-emitting module 1 on the left side is in electrical connection with the first electrical connection surface 111a of the circuit board 11 of the light-emitting module 1 on the right side. In the assembled state, the second superimposed portion 112 of the circuit board 11 of the light-emitting module 1 on the left side completely covers the first electrical connection surface 111a of the circuit board 11 of the light-emitting module 1 on the right side, while the first superimposed portion 111 of the circuit board on the right side completely covers the second electrical connection surface 112a of the circuit board 11 on the left side.

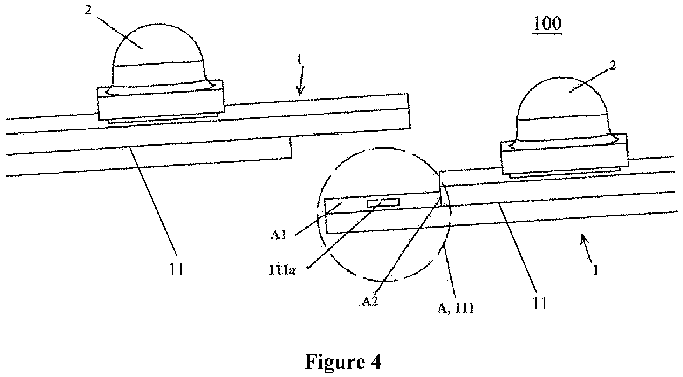

Fig. 4 is a schematic diagram of the opposite end regions of the two circuit boards 11 shown in Fig. 2, viewed at a first angle. The first step-like structure A at the left end portion of the circuit board 11 which serves as the first superimposed portion 111 can be seen from the figure. The first abutment surface A1 of the first step-like structure A which is in parallel with the mounting surface of the circuit board 11, and the second abutment surface A2 perpendicular to the mounting surface can further be seen from the figure. As can be seen from the figure, the first electrical connection surface 111a forms a portion of the first abutment surface A1, and the first electrical connection surface 111a is flush with the first abutment surface A1.

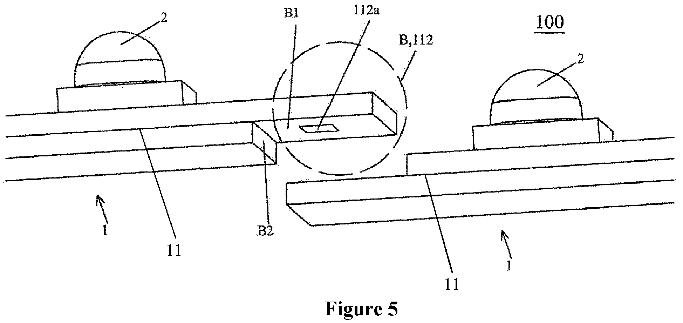

Fig. 5 is a schematic diagram of the opposite end regions of the two circuit boards 11 shown in Fig. 2, viewed at a second angle. The second step-like structure B at the left end portion of the circuit board 11 which serves as the second superimposed portion 112 can be seen from the figure. The first abutment surface B1 of the second step-like structure B which is in parallel with the mounting surface of the circuit board 11, and the second abutment surface B2 perpendicular to the mounting surface can further be seen from the figure. As can be seen from the figure, the second electrical connection surface 112a forms a portion of the first abutment surface B1, and the second electrical connection surface 112a is flush with the first abutment surface B1.

The above is merely preferred embodiments of the present invention but not to limit the present invention. For the person skilled in the art, the present invention may have various alterations and changes.

### List of reference signs

- 1: light-emitting module
- 11: circuit board
- 111: first superimposed portion
- 111a: first electrical connection surface
- 112: second superimposed portion
- 112a: second electrical connection surface
- 113: basic material layer
- 114: insulating layer
- 115: first conductive layer
- 116: second conductive layer
- 2: LED chip
- 3: electrical connection structure
- 31: conductive column
- 32: insulating wall
- A: first step-like structure
- B: second step-like structure
- A1, B1: first abutment surface
- A2, B2: second abutment surface
- 100: LED illumination device

## Claims

1. An LED illumination device (100), comprising at least two light-emitting modules (1) in serial connection, wherein the light-emitting module (1) comprises a circuit board (11) and at least one LED chip (2) arranged on the circuit board (11), wherein the circuit board (11) comprises a first superimposed portion (111) and a second superimposed portion (112) at two opposite ends of the circuit board (11), wherein a first electrical connection surface (111a) is formed in the first superimposed portion (111), and a second electrical connection surface (112a) is formed in the second superimposed portion (112), wherein the first superimposed portion (111) of the circuit board (11) of one of the light-emitting modules (1) at least partially overlaps the second superimposed portion (112) of the circuit board (11) of an adjacent light-emitting module (1), and the first electrical connection surface (111a) of the circuit board (11) of one of the light-emitting modules (1) is in electrical connection with the second electrical connection surface (112a) of the circuit board (11) of an adjacent light-emitting module (1), wherein the first superimposed portion (111) is formed as a first step-like structure (A), the second superimposed portion (112) is formed as a second step-like structure (B), the first step-like structure (A) of the circuit board (11) of one of the light-emitting modules (1) is complementary to the second step-like structure (B) of the circuit board (11) of an adjacent light-emitting module (1), such that connection portions of the circuit boards (11) of the adjacent light-emitting modules (1) are flush with each other in an overlapping region, wherein the first step-like structure (A) and the second step-like structure (B) respectively comprise a first abutment surface (A1, B1) in parallel with the mounting surface of the circuit board (11) and a second abutment surface (A2, B2) perpendicular to the mounting surface, wherein the first abutment surface (A1, B1) and the second abutment surface (A2, B2) form connection surfaces between the circuit boards (11), **characterized in that** the first abutment surface (A1, B1) is designed in a square shape, **in that**
the circuit board (11) comprises a basic material layer (113), an insulating layer (114) arranged on the basic material layer (113), a first conductive layer (115) arranged on the insulating layer (114), and a second conductive layer (116) arranged on the first conductive layer (115), **in that**
the circuit board (11) comprises an electrical connection structure (3), wherein the electrical connection structure (3) includes a conductive column (31), one end of the conductive column (31) being in electrical connection with the second conductive layer (116) and/or the first conductive layer (115), and a free end surface of the other end of the conductive column (31) constituting at least a portion of the first abutment surface (A1, B1) and forming the first electrical connection surface (111a) or the second electrical connection surface (112a), and **in that**
the electrical connection structure (3) further includes an insulating wall (32) surrounding a circumferential surface of the conductive column (31), such that the conductive column (31) is electrically isolated from the basic material layer (113).

2. The LED illumination device (100) according to Claim 1, **characterized in that**, the first superimposed portion (111) or the second superimposed portion (112) of the circuit board (11) of one of the light-emitting modules (1) completely covers the second electrical connection surface (112a) or the first electrical connection surface (111a) of the circuit board (11) of an adjacent light-emitting module (1).

3. The LED illumination device (100) according to Claim 1, **characterized in that**, the first superimposed portion (111) and the second superimposed portion (112) are formed on two opposite mounting surfaces of the circuit board (11), respectively.

4. The LED illumination device (100) according to any of the preceding claims, **characterized in that**, the basic material layer (113) is made of an aluminum material.

5. The LED illumination device (100) according to any of the preceding claims, **characterized in that**, the first conductive layer (115) is made of a copper material, and the second conductive layer (116) is made of a Ni Au material.

6. The LED illumination device (100) according to any of Claims 1-3, **characterized in that**, a conductive paste is applied between the first electrical connection surface (111a) and the second electrical connection surface (112a).

7. The LED illumination device (100) according to any of the preceding claims, **characterized in that**, the first abutment surface (A1, B1) and the second abutment surface (A2, B2) of the circuit board (11) of one of the light-emitting modules (1) are in welded connection with the first abutment surface (A1, B1) and the second abutment surface (A2, B2) of the circuit board (11) of an adjacent light-emitting module (1).

## Patentansprüche

1. LED-Beleuchtungsvorrichtung (100), die mindestens zwei lichtemittierende Module (1) in Reihenschaltung aufweist, wobei das lichtemittierende Modul (1) eine Leiterplatte (11) und mindestens einen LED-Chip (2) aufweist, der auf der Leiterplatte (11) angeordnet ist, wobei die Leiterplatte (11) einen ersten überlagernden Abschnitt (111) und einen zweiten überlagernden Abschnitt (112) an zwei entgegengesetzten Enden der Leiterplatte (11) aufweist, wobei eine erste elektrische Verbindungsfläche (111a) in dem ersten überlagernden Abschnitt (111) gebildet ist und eine zweite elektrische Verbindungsfläche (112a) in dem zweiten überlagernden Abschnitt (112) gebildet ist, wobei der erste überlagernde Abschnitt (111) der Leiterplatte (11) von einem der lichtemittierenden Module (1) den zweiten überlagernden Abschnitt (112) der Leiterplatte (11) eines benachbarten lichtemittierenden Moduls (1) mindestens teilweise überlappt, und die erste elektrische Verbindungsfläche (111a) der Leiterplatte (11) von einem der lichtemittierenden Module (1) elektrisch mit der zweiten elektrischen Verbindungsfläche (112a) der Leiterplatte (11) eines benachbarten lichtemittierenden Moduls (1) verbunden ist, wobei der erste überlagernde Abschnitt (111) als eine erste stufenartige Struktur (A) gebildet ist, der zweite überlagernde Abschnitt (112) als eine zweite stufenartige Struktur (B) gebildet ist, die erste stufenartige Struktur (A) der Leiterplatte (11) von einem der lichtemittierenden Module (1) sich mit der zweiten stufenartigen Struktur (B) der Leiterplatte (11) eines benachbarten lichtemittierenden Moduls (1) ergänzt, derart, dass Verbindungsabschnitte der Leiterplatten (11) der benachbarten lichtemittierenden Module (1) in einem Überlappungsgebiet oberflächenbündig miteinander sind, wobei die erste stufenartige Struktur (A) beziehungsweise die zweite stufenartige Struktur (B) jeweils eine erste Stoßfläche (A1, B1), die parallel zur Anbringungsfläche der Leiterplatte (11) ist, und eine zweite Stoßfläche (A2, B2) aufweisen, die senkrecht zur Anbringungsfläche ist, wobei die erste Stoßfläche (A1, B1) und die zweite Stoßfläche (A2, B2) Verbindungsflächen zwischen den Leiterplatten (11) bilden, **dadurch gekennzeichnet, dass** die erste Stoßfläche (A1, B1) in einer quadratischen Form ausgelegt ist,
dadurch, dass die Leiterplatte (11) eine Grundmaterialschicht (113), eine Isolationsschicht (114), die auf der Grundmaterialschicht (113) angeordnet ist, eine erste leitfähige Schicht (115), die auf der Isolationsschicht (114) angeordnet ist, und eine zweite leitfähige Schicht (116) aufweist, die auf der ersten leitfähigen Schicht (115) angeordnet ist, dadurch, dass
die Leiterplatte (11) eine elektrische Verbindungsstruktur (3) aufweist, wobei die elektrische Verbindungsstruktur (3) eine leitfähige Säule (31) aufweist, wobei ein Ende der leitfähigen Säule (31) elektrisch mit der zweiten leitfähigen Schicht (116) und/oder der ersten leitfähigen Schicht (115) verbunden ist und eine freie Endfläche des anderen Endes der leitfähigen Säule (31) mindestens einen Abschnitt der ersten Stoßfläche (A1, B1) bildet und die erste elektrische Verbindungsfläche (111a) oder die zweite elektrische Verbindungsfläche (112a) bildet, und dadurch, dass
die elektrische Verbindungsstruktur (3) ferner eine isolierende Wand (32) aufweist, die eine Umfangsfläche der leitfähigen Säule (31) umgibt, derart, dass die leitfähige Säule (31) elektrisch von der Grundmaterialschicht (113) isoliert ist.

2. LED-Beleuchtungsvorrichtung (100) nach Anspruch 1, **dadurch gekennzeichnet, dass** der erste überlagernde Abschnitt (111) oder der zweite überlagernde Abschnitt (112) der Leiterplatte (11) von einem der lichtemittierenden Module (1) die zweite elektrische Verbindungsfläche (112a) oder die erste elektrische Verbindungsfläche (111a) der Leiterplatte (11) eines benachbarten lichtemittierenden Moduls (1) vollständig abdeckt.

3. LED-Beleuchtungsvorrichtung (100) nach Anspruch 1, **dadurch gekennzeichnet, dass** der erste überlagernde Abschnitt (111) und der zweite überlagernde Abschnitt (112) jeweils auf zwei entgegengesetzten Anbringungsflächen der Leiterplatte (11) gebildet sind.

4. LED-Beleuchtungsvorrichtung (100) nach einem der vorhergehenden Ansprüche, **dadurch gekennzeichnet, dass** die Grundmaterialschicht (113) aus einem Aluminiummaterial hergestellt ist.

5. LED-Beleuchtungsvorrichtung (100) nach einem der vorhergehenden Ansprüche, **dadurch gekennzeichnet, dass** die erste leitfähige Schicht (115) aus einem Kupfermaterial hergestellt ist und die zweite leitfähige Schicht (116) aus einem Ni-Au-Material hergestellt ist.

6. LED-Beleuchtungsvorrichtung (100) nach einem der Ansprüche 1 bis 3, **dadurch gekennzeichnet, dass** eine leitfähige Paste zwischen der ersten elektrischen Verbindungsfläche (111a) und der zweiten elektrischen Verbindungsfläche (112a) aufgebracht ist.

7. LED-Beleuchtungsvorrichtung (100) nach einem der vorhergehenden Ansprüche, **dadurch gekennzeichnet, dass** die erste Stoßfläche (A1, B1) und die zweite Stoßfläche (A2, B2) der Leiterplatte (11) von einem der lichtemittierenden Module (1) sich in einer Schweißverbindung mit der ersten Stoßfläche (A1, B1) und der zweiten Stoßfläche (A2, B2) der Leiterplatte (11) eines benachbarten lichtemittierenden Moduls (1) befinden.

## Revendications

1. Un dispositif d'éclairage à LED (100) comprenant au moins deux modules électroluminescents (1) en connexion série, dans lequel le module électroluminescent (1) comprend une carte à circuits imprimés (11) et au moins une puce LED (2) agencée sur la carte à circuits imprimés (11), la carte à circuits imprimés (11) comprenant une première partie superposée (111) et une deuxième partie superposée (112) au niveau de deux extrémités opposées de la carte à circuits imprimés (11), une première surface de connexion électrique (111a) étant formée dans la première partie superposée (111) et une deuxième surface de connexion électrique (112a) étant formée dans la deuxième partie superposée (112), la première partie superposée (111) de la carte à circuits imprimés (11) de l'un des modules électroluminescents (1) chevauchant au moins partiellement la deuxième partie superposée (112) de la carte à circuits imprimés (11) d'un module électroluminescent adjacent (1), et la première surface de connexion électrique (111a) de la carte à circuits imprimés (11) de l'un des modules électroluminescents (1) étant en connexion électrique avec la deuxième surface de connexion électrique (112a) de la carte à circuits imprimés (11) d'un module électroluminescent adjacent (1), la première partie superposée (111) étant formée sous la forme d'une première structure en escalier (A), la deuxième partie superposée (112) étant formée sous la forme d'une deuxième structure en escalier (B), la première structure en escalier (A) de la carte à circuits imprimés (11) de l'un des modules électroluminescents (1) étant complémentaire à la deuxième structure en escalier (B) de la carte à circuits imprimés (11) d'un module électroluminescent adjacent (1), de sorte que des parties de connexion des cartes à circuits imprimés (11) des modules électroluminescents adjacents (1) soient à fleur les unes avec les autres dans une zone de chevauchement, la première structure en escalier (A) et la deuxième structure en escalier (B) comprenant respectivement une première surface de butée (A1, B1) parallèle à la surface de montage de la carte à circuits imprimés (11) et une deuxième surface de butée (A2, B2) perpendiculaire à la surface de montage, la première surface de butée (A1, B1) et la deuxième surface de butée (A2, B2) formant des surfaces de connexion entre les cartes à circuits imprimés (11), **caractérisé en ce que** la première surface de butée (A1, B1) est conçue selon une forme carrée,
**en ce que** la carte à circuits imprimés (11) comprend une couche de matériau de base (113), une couche d'isolation (114) agencée sur la couche de matériau de base (113), une première couche conductrice (115) agencée sur la couche d'isolation (114) et une deuxième couche conductrice (116) agencée sur la première couche conductrice (115), **en ce que**
la carte à circuits imprimés (11) comprend une structure de connexion électrique (3), la structure de connexion électrique (3) comprenant une colonne conductrice (31), une extrémité de la colonne conductrice (31) étant en connexion électrique avec la deuxième couche conductrice (116) et/ou la première couche conductrice (115), et une surface d'extrémité libre de l'autre extrémité de la colonne conductrice (31) constituant au moins une partie de la première surface de butée (A1, B1) et formant la première surface de connexion électrique (111a) ou la deuxième surface de connexion électrique (112a), et **en ce que**
la structure de connexion électrique (3) comprend en outre une paroi d'isolation (32) entourant une surface circonférentielle de la colonne conductrice (31), de sorte que la colonne conductrice (31) soit électriquement isolée de la couche de matériau de base (113).

2. Le dispositif d'éclairage à LED (100) selon la revendication 1, **caractérisé en ce que** la première partie superposée (111) ou la deuxième partie superposée (112) de la carte à circuits imprimés (11) de l'un des modules électroluminescents (1) couvre totalement la deuxième surface de connexion électrique (112a) ou la première surface de connexion électrique (111a) de la carte à circuits imprimés (11) d'un module électroluminescent adjacent (1).

3. Le dispositif d'éclairage à LED (100) selon la revendication 1, **caractérisé en ce que** la première partie superposée (111) et la deuxième partie superposée (112) sont formées sur deux surfaces de montage opposées de la carte à circuits imprimés (11), respectivement.

4. Le dispositif d'éclairage à LED (100) selon l'une quelconque des revendications précédentes, **caractérisé en ce que** la couche de matériau de base (113) est composée d'un matériau en aluminium.

5. Le dispositif d'éclairage à LED (100) selon l'une quelconque des revendications précédentes, **caractérisé en ce que** la première couche conductrice (115) est composée d'un matériau en cuivre et la deuxième couche conductrice (116) est composée d'un matériau en Ni Au.

6. Le dispositif d'éclairage à LED (100) selon l'une quelconque des revendications 1 à 3, **caractérisé en ce qu'**une pâte conductrice est appliquée entre la première surface de connexion électrique (111a) et la deuxième surface de connexion électrique (112a).

7. Le dispositif d'éclairage à LED (100) selon l'une quelconque des revendications précédentes, **caractérisé en ce que** la première surface de butée (A1, B1) et la deuxième surface de butée (A2, B2) de la carte à circuits imprimés (11) de l'un des modules électroluminescents (1) sont en raccord soudé avec la première surface de butée (A1, B1) et la deuxième surface de butée (A2, B2) de la carte à circuits imprimés (11) d'un module électroluminescent adjacent (1).
